# EUROPEAN PATENT APPLICATION

(11) **EP 4 637 289 A1**
(43) Date of publication of application: **22.10.2025**
(21) Application number: 24171236.3
(22) Date of filing: 19.04.2024
(51) Int. Cl.: H05K 9/00

(54) **EMC ASSEMBLY**

(71) Applicant: Aptiv Technologies AG, 8200 Schaffhausen (CH)
(72) Inventor: BARUS, Lukasz, 8200 Schaffhausen (CH); SWIERCZ, Karol, 8200 Schaffhausen (CH); KUPCZYK, Pawel, 8200 Schaffhausen (CH); BUDZIAK, Marcin, 8200 Schaffhausen (CH)
(74) Representative: Bardehle Pagenberg Partnerschaft mbB Patentanwälte Rechtsanwälte

(57) **Abstract**

EMC assembly 1, comprising a first electrically conductive housing part 10 with a first electrically conductive elastic means 12, a second electrically conductive housing part 20 with a second electrically conductive elastic means 22, a first printed circuit board PCB 40 and a second printed circuit board PCB 50, a retainer 30 being sandwiched between the first printed circuit board 40 and the second printed circuit board 50 and forming a PCB-retainer sandwich 60, wherein the first electrically conductive elastic means 12 and the second electrically conducting elastic means 22 compress the PCB-retainer sandwich 60 in-between themselves.

## Description

### 1. Field of the invention

The present invention relates to an EMC assembly for electrical components, wherein the EMC assembly provides EMC (Electro-Magnetic Compatibility). Particularly the present invention relates to an EMC assembly where the electrical components are arranged on at least two printed circuit boards (PCBs) and are enclosed within a housing.

### 2. Technical background

Electromagnetic compatibility (EMC) is the ability of electrical equipment and systems to function acceptably in their electromagnetic environment, by limiting the unintentional generation, propagation and reception of electromagnetic energy which may cause unwanted effects such as electromagnetic interference (EMI) or even physical damage to operational equipment. The goal of EMC is the correct operation of different equipment in a common electromagnetic environment.

Usually, assemblies that provide EMC properties comprise a housing that consist of a metallic material that shields electromagnetic radiation and protects from electromagnetic interference. As an alternative, an EMC protected housing can be made of a non-metallic material that is coated with a metallic material for providing EMC properties.

Common assemblies for electronic components that provide EMC comprise often very complex and expensive solutions for EMC protection. Particularly, the parting lines of an EMC housing need special attention and EMC measures. Commonly, a metal-to-metal contact, EMC springs, FIP gaskets, etc. are used at parting lines of EMC housings. Any unwanted apertures where housing parts matches but cannot be in direct touch all along the parting line should be avoided as they can provide slot antenna occurrence or other field leaks. Such apertures are more likely if the housing is prone to assembly errors due to its complexity.

In some applications two PCBs directly one above another are housed in one common housing. In cases where EMC protection requirements are high, internal FIP (Form In Place) dispersed EMC gaskets are used as internal interface to a PCB for EMC shielding. Such a gasket, however, may apply unwanted forces to the PCB that may cause damage to the PCB during use when the preload is excessive over time or when external shocks may apply to the housing.

Therefore, an EMC assembly should be provided that overcomes the above-mentioned problems, particularly that provides good EMC protection and improves reliability of the PCB.

### 3. Summary of the invention

The above-mentioned objects are at least partially achieved by the subject-matter of the independent claim 1. Preferred embodiments are subject of the dependent claims, and the skilled person finds hints for other suitable aspects of the present invention through the overall disclosure of the present application.

The above mentioned problems are particularly by an EMC assembly comprising a first electrically conductive housing part with a first electrically conductive elastic means; a second electrically conductive housing part with a second electrically conductive elastic means; a first printed circuit board (PCB) and a second printed circuit board (PCB); a retainer being sandwiched between the first printed circuit board and the second printed circuit board and forming a PCB-retainer sandwich; wherein the first electrically conducting elastic means and the second electrically conducting elastic means compress the PCB-retainer sandwich in-between themselves.

Since the PCB-retainer sandwich is compressed in-between the first and the second elastic means, the PCB-retainer sandwich is securely held within the assembly but unwanted forces, particularly bending forces onto the PCBs are avoided. The compressed elastic means push both PCBs and the retainer in-between to each other, thereby balancing the forces of the two gaskets. This ensures integrity of the PCBs even under harsh conditions, e.g. mechanical shocks on the EMC assembly. Further thermal stresses of the PCBs can be relieved by such a mounting. Further, since the two PCBs are sandwiched with a retainer in-between the mechanical strength of the assembly is significantly increased compared to a single PCB mounted individually. Further, the retainer can provide additional EMC shielding for electronics on the PCBs. Preferably, the retainer can provide an outer EMC shield at the perimeter of the PCBs. In addition, the electrically conductive elastic means are compressed by the PCBs to secure electrical connection for proper EMC properties of the EMC assembly.

Thus, in applications where two PCBs are placed directly one above another in and need electrically conductive elastic means incorporated on housing parts a retainer is placed between the PCBs which equalizes forces on the PCBs by reaction to electrically conductive elastic means compressing from another side of PCB. Despite of need of balancing forces on one or more PCBs retainer can be designed to meet the EMC and mechanical requirements and reduces bending of PCB to a safe magnitude and prevent damage of the PCBs.

The retainer that is placed between the PCBs is preferably a rigid frame like part that keeps contact with both of the boards in needed areas providing enough support to not bend excessively any PCB due to any force source from another side, wherein the force mainly is due to electrically conductive elastic means compression. Thus, reaction forces from the rigid retainer allow to reduce bend, support the whole EMC assembly and secure the design from breaking of the PCBs, prevent de-attachment of the elastic means in any areas and prevent breaking of the PCBs by avoiding extreme strain conditions on the PCBs.

Thus, the invention allows to use any EMC protection for high demanding designs, particular designs with two overlapping PCBs.

Preferably the first and/or second electrically conductive elastic means can comprise electrically conducting formed in place (FIP) gaskets, electrically conducting foams, electrically conducting springs and any other electrically conducting means that generate reaction forces during compression.

Preferably, the PCB-retainer sandwich is able to float between the elastic means along an assembly direction of the first and second housing parts. Due to the elastic mounting in-between the first and the second gasket the PCB-retainer sandwich is not totally rigidly mounted within the housing parts. Favorably, it can slightly move since the gaskets are elastic. Preferably, the retainer may be kept just by friction and a pin-hole positioning means. Further, it may not correspond precisely with the shape of the elastic means of the counter side of PCB but be in such a shape that still keeps bending forces low and save. The remaining bending forces can be determined during the design of a particular application.

Preferably, the PCB-retainer sandwich is substantially rigid. Thus, in assembled condition there is substantially no movement between the first printed circuit board, the retainer and the second printed circuit board. This further ensures the mechanical stability of the PCBs.

Preferably, the retainer has a substantially flat shape. Thereby, preferably the retainer can support the PCBs along one or their surfaces.

Preferably the retainer contacts one of major surfaces, respectively, of the first printed circuit board and the second printed circuit board.

Preferably, the retainer is electrically conductive. Thus, the retainer can preferably serve as EMC shield or as electrical conductor between the first printed circuit board and the second printed circuit board.

Preferably, the retainer serves as conductor for ground potential between the first printed circuit board and the second printed circuit board.

Preferably, the retainer consists of die casted metal or injection mold plastic or stamped sheet metal.

Preferably, the first housing part and the second housing part form a hollow housing, which encloses the EMC-retainer sandwich.

Preferably, the PCB-retainer sandwich substantially divides the EMC housing into two housing cavities.

Preferably, the retainer further comprises mounting means. By the mounting means, the PCB-retainer sandwich can be mounted within the EMC housing. Additionally, the first printed circuit board and/or the second printed circuit board can be mounted to the retainer by the mounting means. Preferably, the mounting means allow a rigid mounting of the PCBs to the retainer.

Preferably, the retainer further comprises a ventilation grid area. The ventilation grid area allows a cooling air flow to pass through but provides an EMC shield if needed.

Preferably, the first electrically conductive housing part and/or the second electrically conductive housing part, comprise holding means for holding the PCB-retainer sandwich, wherein the holding means limits movement of the PCB-retainer sandwich perpendicular to an assembly direction of the first and second housing parts.

### 4. Brief description of preferred embodiments

In the following, preferred embodiments of the disclosure are disclosed by reference to the accompanying figures.
- Fig. 1:: shows a three-dimensional partial sectional view of an EMC assembly according to an embodiment of the present invention;
- Fig. 2:: shows a partial sectional side view of the EMC assembly of Fig. 1;
- Fig. 3:: shows a three-dimensional view of a retainer of the EMC assembly of Fig. 1; and
- Fig. 4:: shows a three-dimensional view of a second housing part of the EMC assembly of Fig. 1.

### 5. Detailed description of preferred embodiments

In the subsequent passages, the preferred embodiments of the invention are described with reference to the accompanying figures in more detail. It is noted that further embodiments are certainly possible, and the below explanations are provided by way of example only, without limitation. Throughout the present figures and specification, the same reference numerals refer to the same elements. The figures may not be to scale, and the relative size, proportions, and depiction of elements in the figures may be exaggerated for clarity, illustration, and convenience.

It is noted that when features, aspects, and/or embodiments are described herein by the term "substantially", manufacturing tolerances must be taken into consideration. In this manner, minor deviations during any kind of manufacturing, assembling or the like may pertain. Further, manufacturing tolerances, aging effects, or other minor defects or the like may pertain. These are all encompassed by the term "substantially". Although not always explicitly expressed by using the term "substantially", it is understood that the elements, parts, units, shapes, and / or the like described herein may nevertheless comprise such manufacturing tolerances.

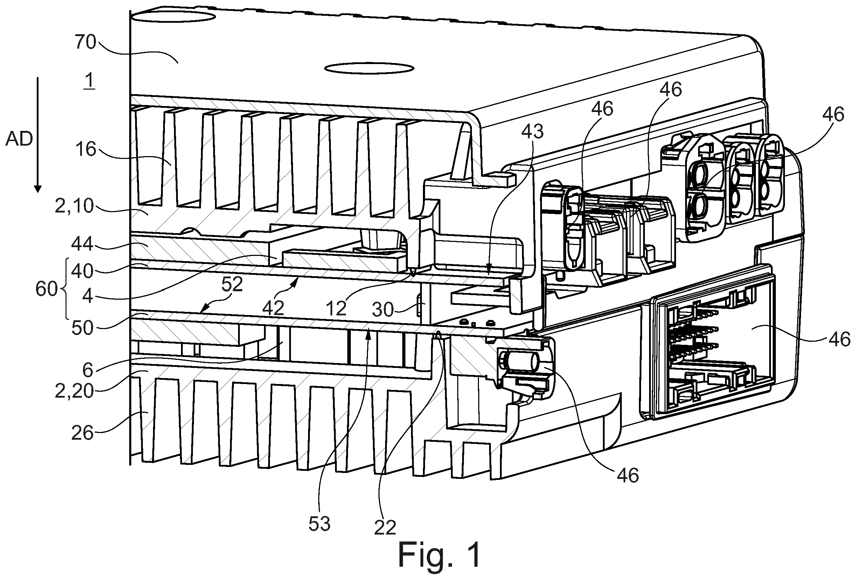

Fig. 1 shows an embodiment of an EMC assembly **1.** The EMC assembly comprises generally of first housing part 10, a second housing part 20, a first PCB 40, a second PCB 50 and a retainer 30. The retainer 30 is arranged or sandwiched in-between the first PCB 40 and the second PCB 50 to form a preferably rigid PCB-retainer sandwich 60.

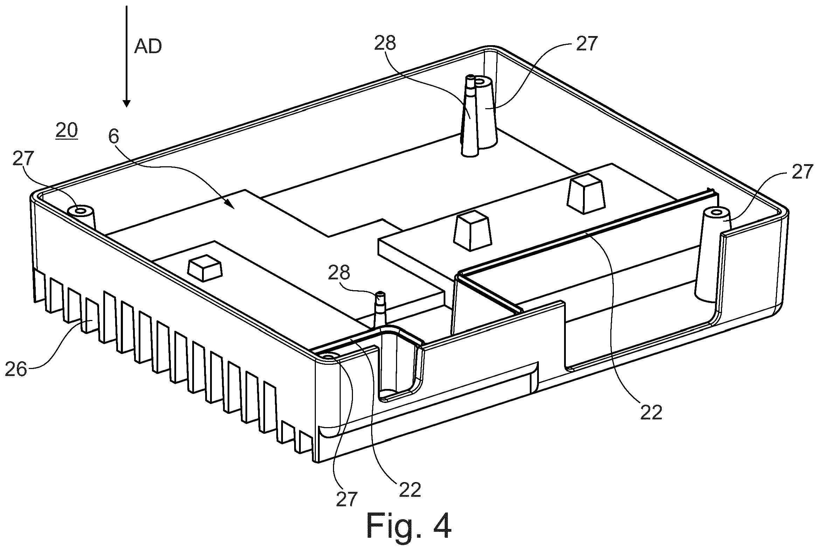

The first housing part 10, a second housing part 20 form a hollow EMC housing 2. The housing parts 10, 20 may be screwed together by screws (not shown) that are screwed through the first housing part 10 into mounting means 27 (see. Fig. 4) of the second housing part 20. The EMC housing 2 is separated or divided by the PCB-retainer sandwich 60 into a first, upper housing cavity 4 and a second, lower housing cavity 6.

The housing parts 10, 20 may be made of die casted metal, like aluminum or zinc or can be made as stamped sheet metal. In any case the housing parts 10, 20 comprise means to fix the EMC features 12, 22 that are to be compressed and which preferably ground the PCB's 40, 50.

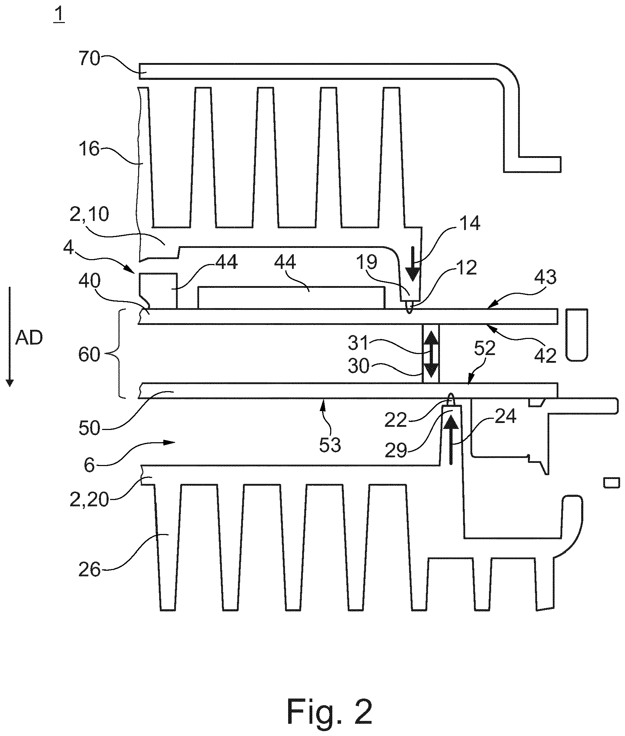

As shown in Fig. 1 and 2 the housing parts 10, 20 may further comprise cooling fins 16, 26 on the outside thereof for dissipating heat generated by the electric or electronic components 44 on the PCBs 40, 50.

The EMC assembly 1 may further comprise a hood 70 on the outside of the first housing part 10. The hood 70 may enclose an electric fan (not shown) for improving cooling the EMC assembly 1.

The first and second PCBs 40, 50 electrically connect and mechanically hold electric and electronic components 44 arranged on their major surfaces 42, 43, 52, 53 in the usual manner. Further the first and second PCBs 40, 50 may hold or be connected to various electric connectors 46 as exemplarily shown in Fig. 1.

The first housing part 10 is electrically conductive to provide EMC properties for the electric and electronic components 44 on the PCBs 40, 50. Further, the first housing part 10 comprises a first electrically conductive elastic means 12, preferably in form of a first electrically conductive formed in place (FIP) gasket 12 for holding and EMC sealing the PCB-retainer sandwich 60. As shown in Figs. 1 and 2 the formed in place (FIP) gasket 12 presses onto an outer major surface 43 of the first PCB 40 and tries to push the PCB-retainer sandwich 60 downwards as indicated by arrow 14 in Fig. 2.

Likewise, the second housing part 20 is electrically conductive to provide EMC properties. Further, the second housing part 20 comprises a first electrically conductive elastic means 12, preferably in form of a second electrically conductive formed in place (FIP) gasket 22 for holding and EMC sealing the PCB-retainer sandwich 60. As shown in Figs. 1 and 2 the formed in place (FIP) gasket 22 presses onto an outer major surface 53 of the second PCB 50 and tries to push the PCB-retainer sandwich 60 upwards as indicated by arrow 24 in Fig. 2.

The first and second electrically conductive elastic means 12, 22 serve as EMC means for shielding off unwanted electromagnetic radiation and further for holding the PCB-retainer sandwich 60 in-between by compression and preferably friction. The electrically conductive elastic means 12, 22 can be electrically conducting formed in place (FIP) gaskets, electrically conducting foams or electrically conducting springs or any other electrically conducting means that generate reaction forces during compression. Electrically conducting formed in place (FIP) gaskets 12, 22 are preferred as they can be automatically applied to the housing parts 10, 20 by NC machines or robots. However, in other applications in the same manner any spring like means may be used for grounding of housing like metallic springs, separate multiple foams, etc..

Thereby, the first gasket 12 and the second gasket 22 compress the PCB-retainer sandwich 60 in-between themselves in order to secure the PCBs within the EMC housing 11. The compression forces (see arrows 14, 24) of the first gasket 12 and the second gasket 22 are equalized by the retainer 30 arranged in-between the PCBs 40, 50 as indicated by arrow 31 in Fig. 2. Thus, by pressing from both sides onto the rigid PCB-retainer sandwich 60 the FIP gaskets 12, 22 the forces (arrows 14 and 24) equalize such that the PCBs 40, 50 are not subjected to any excessive and dangerous bending forces.

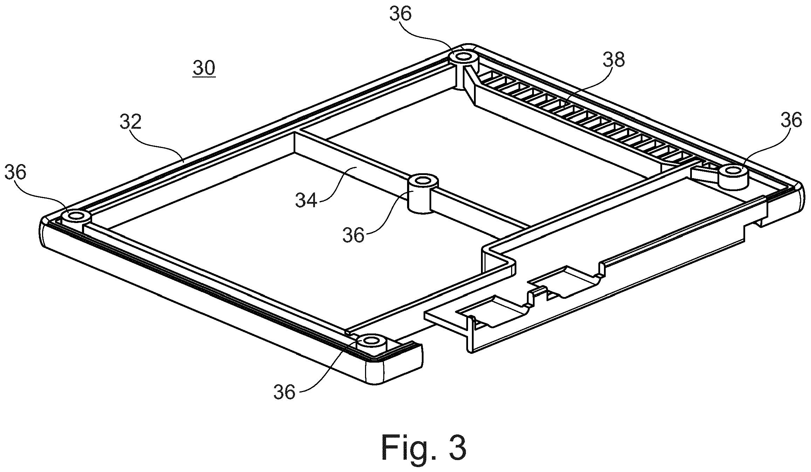

Preferably, the PCB-retainer sandwich 60 is mounted within the EMC housing 2 such that it can at least slightly move in assembly direction AD of the housing parts 10, 20, which enables to the PCB-retainer sandwich 60 to float between the FIP gaskets 12, 22. Such a mounting can be accomplished by rigid posts 28 (see Fig. 4) that are part of the housing parts 10, 20 and/or mounting screws (not shown) and which extend with play through mounting holes 36 of the retainer 30 (see Fig. 3) and corresponding mounting holes of the PCBs 40, 50 (not shown). In a direction perpendicular to the assembly direction AD such posts 28 and/or mounting screws limit movement of the PCB-retainer sandwich 60 to secure it in place within the EMC housing 2.

The FIP gaskets 12, 22 are formed of a compressible, electrically conducting foam that is directly applied to gasket flanges 19, 29 of the first and second housing parts 10, 20. As shown in Fig. 2 the gasket flanges 19, 29 and the FIP gaskets 12, 22 substantially oppose each other to clamp the PCB-retainer sandwich 60 in-between. The FIP gaskets 12, 22 are preferably made of polyolefin foam that is metallized by copper or nickel. Alternatively, the FIP gaskets 12, 22 can be made of an electrically conductive PE or PUR foam. The FIP gaskets 12, 22 are preferably directly applied to the corresponding gasket flanges 19, 29.

As shown in Fig. 3 in some detail the retainer 30 is a substantially frame-like part. It has a substantially flat shape. The retainer 30 comprises an outer frame 32 that substantially surrounds the electric or electronic components 44 on the PCBs 40, 50 for EMC shielding. Further, the retainer 30 may comprise an inner frame element 34 to EMC separate areas on the PCBs 40, 50 or to improve mechanical stability. As shown in Fig. 3, the inner frame element 34 supports a mounting hole 36 at an inner area of the PCBs. In some applications the retainer 30 may be a sole inner part just to balance forces. Then outer perimeters of the retainer 30 are still enclosed by the outer housing parts 10, 20, which are mating directly to each other.

As shown in Fig. 2, the retainer 30 contacts one of inner major surfaces 42, 52, respectively, of the first PCB 40 and the second PCB 50. Further, the retainer 30 may also be electrically conductive and serve as electric connection between the PCBs, preferably to conduct ground potential between the two PCBs 40, 50. To this end the mounting means 36 of the retainer can also be used electrically conductive mounting of electronical components. In addition, the retainer 30 may serves as additional EMC shield.

The retainer 30 may further comprise a ventilation grid area 38 that enables a ventilation air flow between the first, upper housing cavity 4 to the second, lower housing cavity 6. The ventilation grid provides narrow openings that allow an air flow to pass through. On the other hand, the electrically grounded webs of the ventilation grid area 38 EMC shield between the first, upper housing cavity 4 to the second, lower housing cavity 6.

The retainer 30 may be made of a die casted metal to be electrically conductive and to be mechanically stable to balance out the compression forces of the gaskets 12, 22. In an alternative the retainer 30 may be made of an injection molded plastic material that is electrically conductive or that is covered or plated with an electrically conductive material. In some applications the retainer 30 may be stamped from sheet metal with proper flanges and embosses to secure the designated functionality.

### List of reference signs

- 1: EMC assembly
- 2: EMC housing
- 4: first housing cavity
- 6: second housing cavity
- 10: first housing part
- 12: first FIP gasket
- 14: arrow
- 16: cooling fins
- 19: gasket flange
- 20: second housing part
- 22: second FIP gasket
- 24: arrow
- 26: cooling fins
- 27: mounting means
- 28: posts
- 29: gasket flange
- 30: retainer
- 31: arrow
- 32: outer frame
- 34: inner frame element
- 36: mounting means/opening
- 38: ventilation grid area
- 40: first printed circuit board
- 42: inner major surface
- 43: outer major surface
- 44: electric or electronic components
- 46: electric connectors
- 50: second printed circuit board
- 52: inner major surface
- 53: outer major surface
- 60: PCB-retainer sandwich
- 70: hood

## Claims

1. EMC assembly (1); comprising:
a. a first electrically conductive housing part (10) with a first electrically conductive elastic means (12);
b. a second electrically conductive housing part (20) with a second electrically conductive elastic means (22);
c. a first printed circuit board (PCB) (40) and a second printed circuit board (PCB) (50);
d. a retainer (30) being sandwiched between the first printed circuit board (40) and the second printed circuit board (50) and forming a PCB-retainer sandwich (60); wherein
e. the first electrically conductive elastic means (12) and the second electrically conducting elastic means (22) compress the PCB-retainer sandwich (60) in-between themselves.

2. EMC assembly according to claim 1, wherein the first and/or second electrically conductive elastic means (12, 22) are electrically conducting formed in place (FIP) gaskets, electrically conducting foams or electrically conducting springs.

3. EMC assembly according to one of the claims 1 or 2, wherein the PCB-retainer sandwich (60) is able to float between the electrically conductive elastic means (12, 22) along an assembly direction (AD) of the first and second housing parts (10, 20).

4. EMC assembly according to one of the claims 1 to 3, wherein the PCB-retainer sandwich (60) is substantially rigid.

5. EMC assembly according to one of the claims 1 to 4, wherein the retainer (30) has a substantially flat shape.

6. EMC assembly according to one of the claims 1 to 5, wherein the retainer (30) contacts one of major surfaces (42, 52), respectively, of the first printed circuit board (40) and the second printed circuit board (50).

7. EMC assembly according to one of the claims 1 to 6, wherein the retainer (30) is electrically conductive.

8. EMC assembly according to claim 7, wherein the retainer (30) serves as EMC shield.

9. EMC assembly according to one of the claims 7 or 8, wherein the retainer (30) serves as electrical conductor between the first printed circuit board (40) and the second printed circuit board (50).

10. EMC assembly according to claim 9, wherein the retainer (30) serves as conductor for ground potential between the first printed circuit board (40) and the second printed circuit board (50).

11. EMC assembly according to one of the claims 1 to 10, wherein the retainer (30) consists of die casted metal or injection mold plastic or stamped sheet metal.

12. EMC assembly according to one of the claims 1 to 11, wherein the first housing part (10) and the second housing part (20) form a hollow EMC housing (2), which encloses the EMC-retainer sandwich (60).

13. EMC assembly according to claim 12, wherein PCB-retainer sandwich (60) substantially divides the housing (11) into two housing cavities (4, 6).

14. EMC assembly according to one of the claims 1 to 13, wherein the retainer (30) further comprises a ventilation grid area (38).

15. EMC assembly according to one of the claims 1 to 14, wherein the first electrically conductive housing part (10) and/or the second electrically conductive housing part (20), comprise holding means (28) for holding the PCB-retainer sandwich (60), wherein the holding means (28) limits movement of the PCB-retainer sandwich (60) perpendicular to an assembly direction (AD) of the first and second housing parts (10, 20).
